# EUROPEAN PATENT APPLICATION

(11) **EP 4 794 458 A1**
(43) Date of publication of application: **19.08.2026**
(21) Application number: 25158393.6
(22) Date of filing: 17.02.2025
(51) Int. Cl.: H05K 3/28, H05K 1/02, H05K 3/34, H05K 3/40, H05K 3/12

(54) **IMPROVED SCREEN PRINTING PROCESS**

(71) Applicant: Nederlandse Organisatie voor toegepast- natuurwetenschappelijk onderzoek TNO, 2595 DA 's-Gravenhage (NL)
(72) Inventor: RUBINGH, Jan-Eric Jack Martijn, 2595 DA 's-Gravenhage (NL); SMITS, Edsger Constant Pieter, 2595 DA 's-Gravenhage (NL); CHIAPPINI, Francesca, 2595 DA 's-Gravenhage (NL); FARRUGIA, Mark Luke, 6534 AT Nijmegen (NL)
(74) Representative: V.O.

(57) **Abstract**

A method for processing an arrangement (1) comprising a substrate (2) having mounted thereon one or more functional elements (3a, 3b, 3c) is provided herein. The method comprises:
arranging (S1) a screen (4) comprising a screen mesh (41) provided with a mask (42) fixed to the screen mesh and that defines a pattern of openings (43) through the screen, the mask (42) including mask pattern elements (44,45) that extend with a mutually different distance towards the arrangement (1);
supplying (S2) a solidifiable visco-plastic material (5) from a side (46S) of the screen (4) facing away from the arrangement (1) through the openings (43) in the mask (4);
removing (S3) the screen (4);
solidification processing (S4) the solidifiable visco-plastic material (5).

## Description

### BACKGROUND

The present application pertains to a method for processing an arrangement involving an improved screen printing process.

Screen printing is a well known technology used in manufacturing processes of electronic products. In a screen printing process a screen comprising a screen mesh provided with a mask is arranged against a target surface onto which a solidifiable visco-plastic material is to be printed. The solidifiable visco-plastic material to be printed is supplied from a side of the screen facing away from the target surface through the openings in the mask and subsequent to removal of the screen from the target surface, the visco-plastic material is processed for solidification to obtain a solid functional material.

This technology provides a very efficient approach for various applications, such as creating conductive traces, solder masks, and component labels on a planar surface, such as a printed circuit board (PCBs) surface. Screen printing on a non-planar arrangement, substrate with topology, such as a substrate having functional elements mounted thereon however is challenging and results in poor printing quality (e.g. non-homogenous layer thickness, poor resolution of features, material bleed and contamination issues). Furthermore, when printing on topology, the printed material will conform to the existing topology making it difficult to planarize the structures through a printing process. Still further, screen printing on fragile structures like wire bonds, or functionalized surfaces of sensors, leads in damages of the structures because the printing process relies on the mechanical contact of the screen emulsion with the printing area. For these reasons, screen printing is not used for example in the process of realizing the encapsulation of a semiconductor package.

### SUMMARY

It is an object of the present invention to provide a method for processing an arrangement involving an improved screen printing process that mitigates one or more of the above-mentioned disadvantages. Therewith the method is more suitable for printing on an arrangement that comprises a substrate having mounted thereon one or more functional elements and therewith has a non-planar topology. Exemplary functional elements are for example a die, an encapsulated die, an optical component, an electronic component, a microfluidic component, a printed structure or another element resulting in a non-planar topology. The substrate on which the functional elements are arranged may be provided as a temporary carrier only during the processing steps, but may alternatively remain as part of the manufactured product.

In accordance with the above-mentioned object, an improved method is provided as defined in claim 1 of the present application.

The claimed method comprises the following steps.

A screen is positioned on the arrangement comprising the substrate with the one or more functional elements mounted thereon. The screen comprises a screen mesh provided with an emulsion mask that is fixed to the screen mesh and that defines a pattern of openings through the screen. The mask includes mask pattern elements that extend with a mutually different distance towards the arrangement.

Then a solidifiable visco-plastic material is forced from a side of the screen that faces away from the arrangement, through the openings in the mask and is deposited on the arrangement. Typically a screen printing ink or paste ink is used for this purpose and a squeegee may be used for forcing the visco-plastic material through the openings. Visco-plastic materials for this purpose have a high viscosity, e.g. in the range of 1-100 Pa.s, so that they can be deformed and caused to flow under a sufficiently high pressure, but in the absence of a pressure maintain their current shape. The visco-plastic material may further have a thixotropic index higher than 1, e.g. of about 3. I.e. its viscosity in a stationary state is higher than that in a dynamic state so that it can be processed relatively easily while still maintaining its shape in the absence of external forces.

Subsequent to supplying the solidifiable visco-plastic material the screen is removed. Due to its high viscosity and optionally also thixotropic nature the solidifiable visco-plastic material at least substantially maintains the shape as defined by the mask in the preceding step.

After removal of the screen the solidifiable visco-plastic material is processed to cause it to solidify, so that it forms a functional material, such as an encapsulation or an electrical interconnection. Dependent on the type of solidifiable visco-plastic material this may be achieved by curing (e.g. UV-curing or thermal curing) and/or drying and/or sintering.

As specified herein, the mask is fixed to the screen mesh and includes mask pattern elements that extend with a mutually different distance towards the arrangement to be processed.

Therewith the improved method renders possible various deposition steps for the purpose of processing an arrangement comprising a substrate having mounted thereon one or more functional elements.

In an exemplary embodiment, the mask includes at least one first mask pattern element that contacts the functional element wherein the visco-plastic material, after solidification processing, is an encapsulation material. After the mask is removed and the visco-plastic material is processed, the functional element is encapsulated while maintaining an opening in the encapsulation that exposes a portion of the surface of the functional element. The exposed surface portion of the functional element is for example an electrical or thermal contact pad or a part of a sensor, such as an image sensor or an acoustic sensor that is enabled therewith to receive optic or acoustic signals from the environment through the opening in the encapsulation. In some examples of this exemplary embodiment the preceding steps are followed by a subsequent step wherein the opening is filled with a substance differing from the substance used for the encapsulation. For example, the substance different from the encapsulation material is an electrically conductive material that provides an electrical connection to an electric contact of the at least one functional element. The electrically conductive material may for example be provided as an electrically conductive paste or be deposited in an electro-plating process. In another example the substance different from the encapsulation material is a transparent material that provides an optical pathway to a light sensor or image sensor of the at least one functional element.

In an embodiment, the mask includes at least one second mask pattern element that contacts the substrate when the screen is arranged, wherein the visco-plastic material after solidification processing is an encapsulant. The presence of the at least one second mask pattern element reduces a pressure of the screen on the at least one functional element. Upon removal of the screen an opening remains in the deposited visco-plastic material encapsulant e.g. dielectric layer. Before or after solidification processing the opening may give access to the surface of the substrate or to an electric contact on the surface. In an example the removal of the screen is succeeded by a further step wherein the resulting opening is filled with an electrically conductive material to provide an electric connection with the electric contact on the surface.

In some embodiments the mask comprises at least one opening that extends towards a surface of the substrate facing the mask. Therewith, upon removal of the mask, a layer of deposited solidifiable visco-plastic material is formed on the substrate surface. The material, when solidified serves to reduce height differences relative to the surfaces of the one or more functional elements. In this embodiment the deposited layer may have a height that is slightly less than that of the functional elements to avoid the risk that minor tolerances in production parameters cause the visco-plastic material to spread over the surface of the functional elements.

In some embodiments respective mask pattern elements have a respective height that is complimentary to a height of respective functional elements arranged on the substrate. Therewith, when the screen is positioned against the arrangement the respective pattern elements are in contact with an upper surface of said respective functional elements, while the mesh of the screen extends in a single plane.

In some embodiments the mask pattern elements comprise at least a first mask pattern element configured to contact an upper surface of a functional element and a second mask pattern element configured to extend alongside the functional element while providing for a space between the upper surface of the substrate and a surface of said second mask pattern element facing the upper surface of the substrate. Therewith the curable material protrudes in the space so that upon removal of the mask the lower part of the functional element is embedded in the curable material, e.g. molding material.

In some embodiments at least one of the functional elements is wirebonded on the substrate with electrically conducting wires and in the step of positioning the mask, pattern elements support the screen on the surface of the functional elements and/or on the surface of the substrate. Therewith a mechanical contact between the screen and the electrically conducting wires is avoided.

The improved method has a wide applicability. The one or more functional elements mounted on the substrate may comprises one or more of a die, an encapsulated die, an optical component, an electronic component, a microfluidic component or a printed structure.

As a preparation prior to the actual deposition method a screen may be provided by repeating the following steps: application of a layer of photosentitive material e.g. screen emulsion, patterning the photosensitive material through light exposure and subsequently removing unwanted parts. More specifically preparations may proceed as follows. The materials for constructing the mask will generally be denoted 'curable screen emulsion' in the state before curing. The materials when cured are denoted as 'cured screen emulsion'.

A screen mesh is provided and a first amount of curable material, for example a photopatternable material e.g. screen emulsion is deposited according to a first pattern on the screen mesh. The emulsion may be provided in dry film form or liquid form and be deposited with a thickness in a range of about 10 um to about 1 mm The first amount of curable screen emulsion, is cured, for example by irradiation with photon radiation. The cured screen emulsion provides for at least a first mask pattern element and at least a second pattern element. In the deposition process the first amount of curable screen emulsion partly penetrates into the screen mesh so that it becomes adhered thereto when it is subsequently cured.

Subsequently a second amount of curable screen emulsion, which may or may not be of the same type as that of the first amount, type of curable screen emulsion is selectively deposited on the at least one second pattern element, therewith not covering the at least the first mask pattern element. By subsequently curing the subsequently deposited curable screen emulsion at least a third pattern element of cured screen emulsion is formed that is stacked on the second pattern element. The second pattern element and the third pattern element stacked thereon together form a second mask pattern element.

As noted, the curable screen emulsion in this subsequent deposition step may be the same type of curable screen emulsion as the material that was deposited on the screen mesh, but may alternatively be a different type of curable screen emulsion, dependent on required material characteristics of the cured screen emulsion. For example the subsequently cured screen emulsion, i.e. the cured screen emulsion of the at least a third pattern element has a hardness lower than that of the first mask pattern element and the second pattern element. More generally a cured screen emulsion used for a layer in the screen that in use is closest to the substrate may have a relatively low elasticity modulus to mitigate stress or a higher modulus to give less deformation under pressure and provide a better resolution.

In an embodiment the mask comprises two or more patterned mask layers, comprising a contact mask layer that is most remote from the screen mesh and is configured to contact a deposition target and an intermediate mask layer that is arranged between the contact mask layer and the screen mesh, wherein the contact mask layer has at least one set of two or more openings through which a solidifiable visco-plastic substance can be deposited, and wherein the intermediate mask layer has at least a corresponding opening that gives access to the set of two or more openings. On the one hand the openings in the contact mask layer can be relatively small, therewith rendering it possible to deposit detailed structures. On the other hand, the corresponding opening in the intermediate layer that gives access to the set of two or more openings will have a larger cross-section than the individual openings in the contact mask layer, so that deposition can take place with a relatively low pressure.

### BRIEF DESCRIPTION OF THE DRAWINGS

These and other aspects are described in more detail with reference to the drawing. Therein:
FIG. 1A-1F schematically show an embodiment of an improved method for processing an arrangement that comprises a substrate having mounted thereon one or more functional elements;
FIG. 2 shows an alternative embodiment of the improved method;
FIG. 3 and 3A show a still further embodiment of the improved method;
FIG. 4A, 4B and 4C show a still further embodiment of the improved method;
FIG. 5A, 5B show again another embodiment of the improved method;
FIG. 6A to 6F shows exemplary preparatory steps wherein a screen is provided for use in embodiments of the improved method;
FIG. 7A, 7AB, 7B, 7BB, 7C, 7CB and 7D show how the screen as used in the application of FIG. 4A - 4C may be provided in preparatory steps.

### DETAILED DESCRIPTION OF EMBODIMENTS

In the following detailed description numerous specific details are set forth in order to provide a thorough understanding of the present invention. However, it will be understood by one skilled in the art that the present invention may be practiced without these specific details. In other instances, well known methods, procedures, and components have not been described in detail so as not to obscure aspects of the present invention.

Like reference symbols in the various drawings indicate like elements unless otherwise indicated.

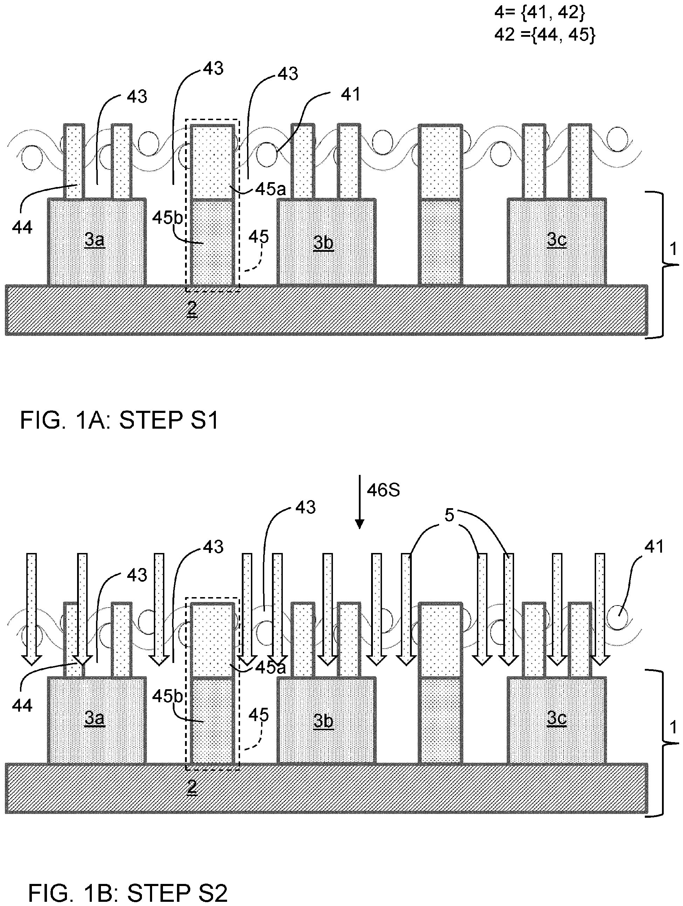

FIG. 1A-1F schematically show steps of a method for processing an arrangement 1 that comprises a substrate 2 having mounted thereon one or more functional elements 3a, 3b, 3c. The one or more functional elements comprise one or more of a die, an encapsulated die, an optical component, an electronic component, a microfluidic component or a printed structure. The substrate 2 for example comprises electrical conductors (e.g. as in a printed circuit board (PCB), leadframe) and/or optical waveguides to connect the one or more functional elements to one or more external modules and/or to mutually interconnect functional elements. In some embodiments the substrate 2 is a temporary carrier substrate. For example, a temporary carrier substrate may be used in case the method provides for an encapsulation of the one or more functional elements 3a, 3b, 3c the supporting functionality of the substrate 2 may no longer be necessary upon completion of the method.

FIG. 1A shows a step S1 wherein a screen 4 is arranged against the arrangement 1. As shown in FIG. 1A, the screen 4 comprises a screen mesh 41. The screen mesh 41 may consist of woven polyester threads but preferably consists of stainless steel threads. The mesh count is typically in the range of 500-180. This is tuned by varying the mesh width from 25 um to 80 um and the thread diameter from 15 - 50 um. Such a mesh is commercially available, for example from Berbertech or Asahitec.

A mask, composed of a cured photosensitive resist or emulsion 42 is fixed to the screen mesh and defines a pattern of openings 43 through the screen. The mask 42 includes mask pattern elements 44,45 that extend with a mutually different distance towards the arrangement 1. The mask 42 is obtained by repeating the following steps: application of a layer of photosentitive material e.g. screen emulsion, pattern the photosensitive material through light exposure and subsequently removing unwanted parts.

In the example shown, the mask 42 includes at first mask pattern element 44 that contacts the functional elements 3a, 3b, 3c. Non limiting examples of functional elements are semiconductor dies, passive component and optical components. The exemplary mask 42 also includes second mask pattern elements 45 that contact the substrate 2. Therewith the screen 4 is well supported by the substrate and the functional elements and arranged in a plane parallel to the substrate.

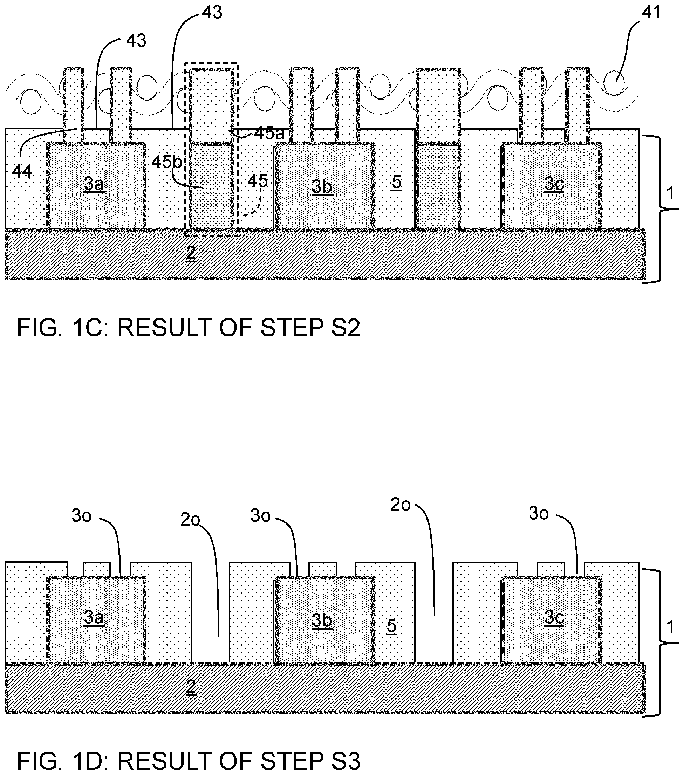

FIG. 1B shows a subsequent step S2, wherein a solidifiable visco-plastic material 5 is supplied from a side 46S of the screen 4 facing away from the arrangement 1 and allowed to protrude through the openings 43 in the screen 4 in the space present between the arrangement and the mask, resulting in the situation of FIG. 1C.

In subsequent step S3, shown in FIG. 1D the screen 4 is removed. It can be seen that the functional elements 3a, 3b, 3c are now encapsulated in the solidifiable visco-plastic material 5. As shown in FIG. 1D now openings 3o exposing a surface of the functional elements are provided at the locations of the pattern elements 44 in the preceding step S2. Likewise openings 2o exposing a surface of the substrate 2 are provided at the locations of the pattern elements 45 in the preceding step S2. As noted above, the solidifiable visco-plastic material has a high viscosity so that in the absence of external forces it will not significantly deform even if the material 5 has not yet been solidified. Nevertheless minor deformations could occur so that the drawing may slightly deviate from reality.

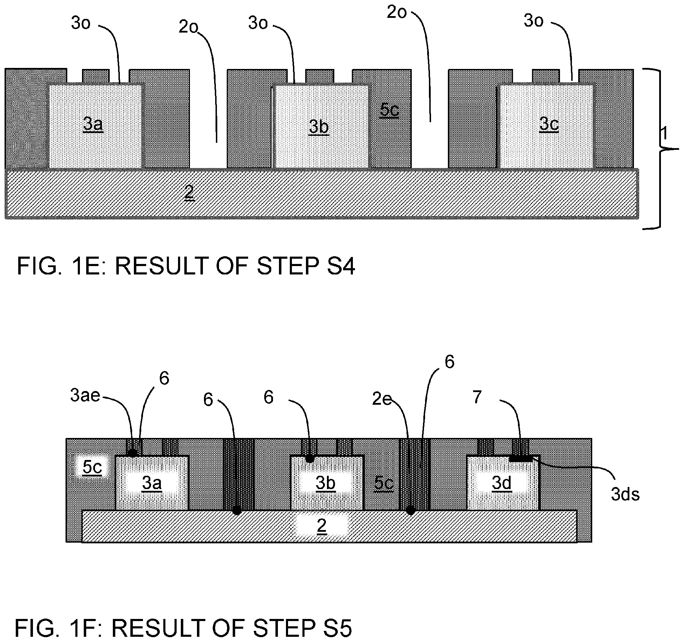

In subsequent step S4 the solidifiable visco-plastic material 5 is solidification processed, so that the functional elements 3a are embedded in the solidified material 5c, e.g. an encapsulation material as shown in FIG. 1E. It is noted that the solidifiable visco-plastic material typically is a thermally curable material. This implies that in step S4, the solidifiable visco-plastic material is cured by heat after the material is deposited through the openings 43 in the screen 4. Alternatively, the visco-plastic material may be a UV-curable material.

FIG. 1F shows an optional further step wherein openings 2o, 3o in the encapsulation material are filled with a substance 6, 7 different from the encapsulation material 5c. For example, the openings 2o, 3o are filled with an electrically conductive material 6 to provide an electrical connection with an electrical contact 3ae on the functional element 3a. In another example an opening 3o is filled with a translucent material 7 to allow light to access a light sensor 3ds of the functional element 3d. As another example an opening 2o is filled with an electrically conductive material 6 to provide an electrical connection with an electrical contact 2e on the substrate.

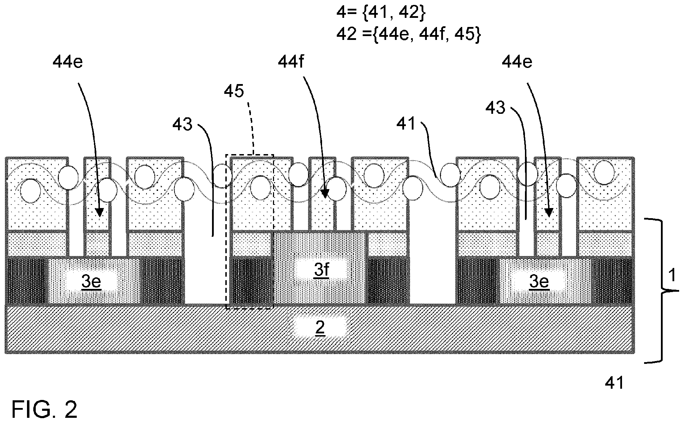

FIG. 2 shows an alternative embodiment, wherein in step S1 of the method a screen 4 is arranged of which the mask 42 has specific pattern elements 44e, 44f with a respective height that is complimentary to a height of respective functional elements 3e, 3f arranged on the substrate 2. In the example shown, two relatively low components 3e and one relatively high component 3f is arranged on the substrate 2 and the mask 42 comprises corresponding pattern elements 44e, 44f. Also the mask has pattern elements 45 that contact the surface of the substrate 2 when the screen 4 is arranged in step S1. Therewith a force exerted by the screen 4 through the squeegee is properly distributed over the surface of the arrangement 1 and the screen mesh 41 can be maintained aligned with a plane parallel to the surface of the substrate.

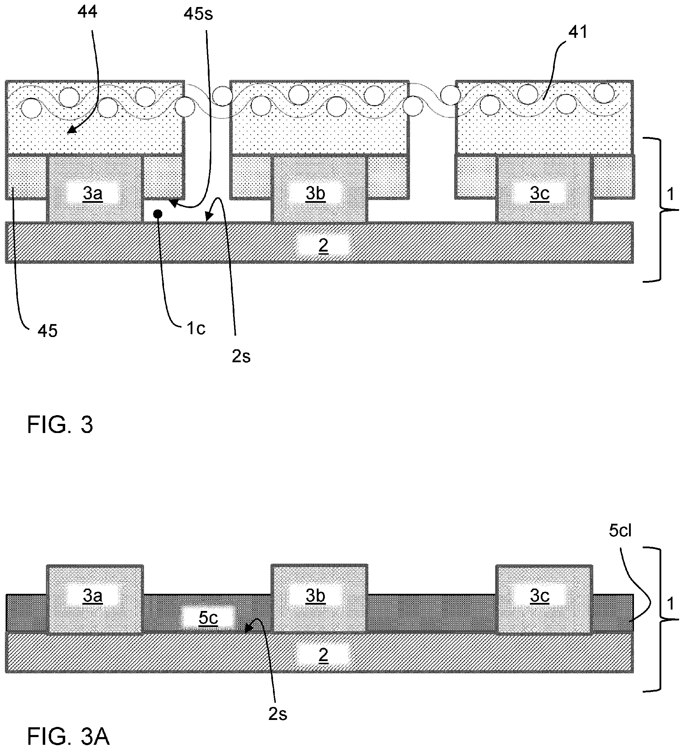

FIG. 3 shows an embodiment of the method wherein the mask pattern elements 44,45 comprise first mask pattern elements 44 that are configured to contact an upper surface of the functional elements 3a, 3b, 3c and second mask pattern elements 45 that are configured to extend alongside the functional elements. The second mask pattern elements 45 provide for a space 1c between the upper surface 2s of the substrate 2 and a surface 45s of said second mask pattern element that faces the upper surface 2s of the substrate 2. Therewith cavities 1c are provided underneath the second mask pattern elements 45.

FIG. 3A shows that the cured material 5c, that results after the screen 4 is removed, and after solidification processing of the solidifiable visco-plastic material is patterned in the form of a base layer 5cl that covers the surface of the substrate around the functional elements 3a, 3b, 3c. Layer 5cl allows a reduction of the step height in a controlled manner with respect of the top to the die, which simplifies subsequent printing steps.

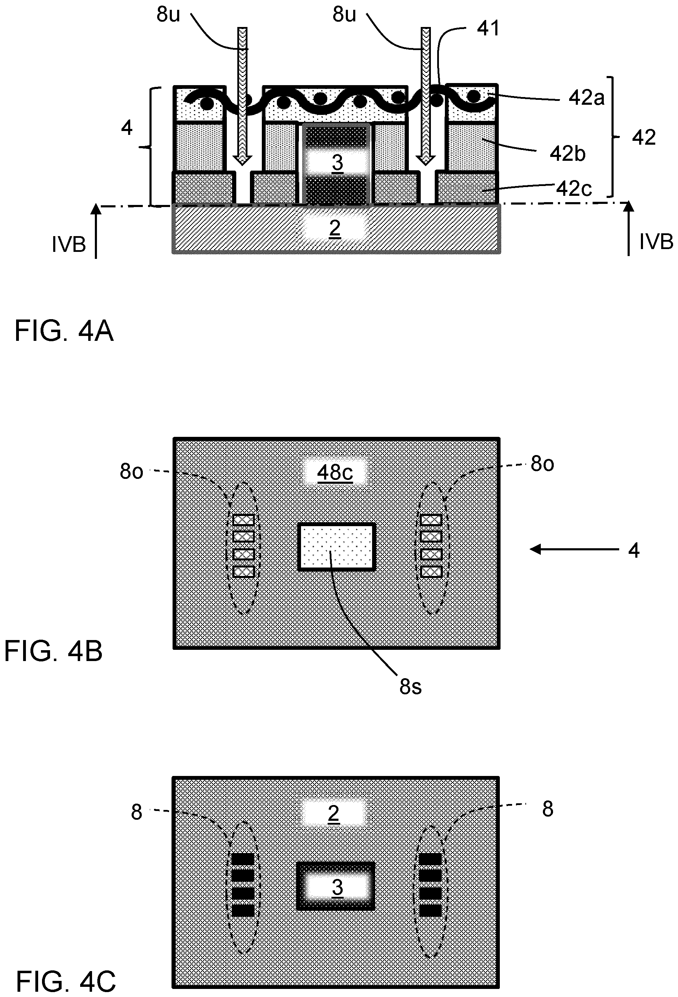

FIG. 4A, 4B and 4C show a further application, wherein an embodiment of the improved method is used to deposit electric contacts 8 (See FIG. 4C) on the substrate 2. As shown in FIG. 4A, the screen mask 42 comprises a first mask layer 42a, a second mask layer 42b, and a third mask layer 42c. The second mask layer 42b, and a third mask layer 42c respectively are an intermediate mask layer and a contact mask layer. As best shown in FIG. 4B, which shows the screen 4 from a side facing the substrate 2 (IVB-IVB in FIG. 4A), the screen 4 has a space 8s for accommodating the functional element 3 and sets of openings 8o. The space 8s is capped by the first mask layer 42a that during deposition rests on an upper surface of the functional element 3. The openings 8o in the mask render it possible to deposit a solidifiable visco-plastic substance 8u through the mesh onto the substrate surface, as is illustrated by the block arrows in FIG. 4A. FIG. 4C shows a top view of the substrate 2 being provided with the functional element 3 and the electric contacts 8 after the deposited substance 8u is cured and the mask screen 4 has been removed. As can already be seen in FIG. 4A and 4B, the deposition pattern is defined by the third mask layer 42c. The screen 4 as shown in FIG. 4A and 4B renders it possible to deposit detailed structures, such as the electric contacts 8. As the narrow openings 8o that define the detailed structures are only present in the third mask layer 42c while larger openings are provided in the first and the second mask layer 42a, 42b it is achieved that deposition can take place with a relatively low pressure.

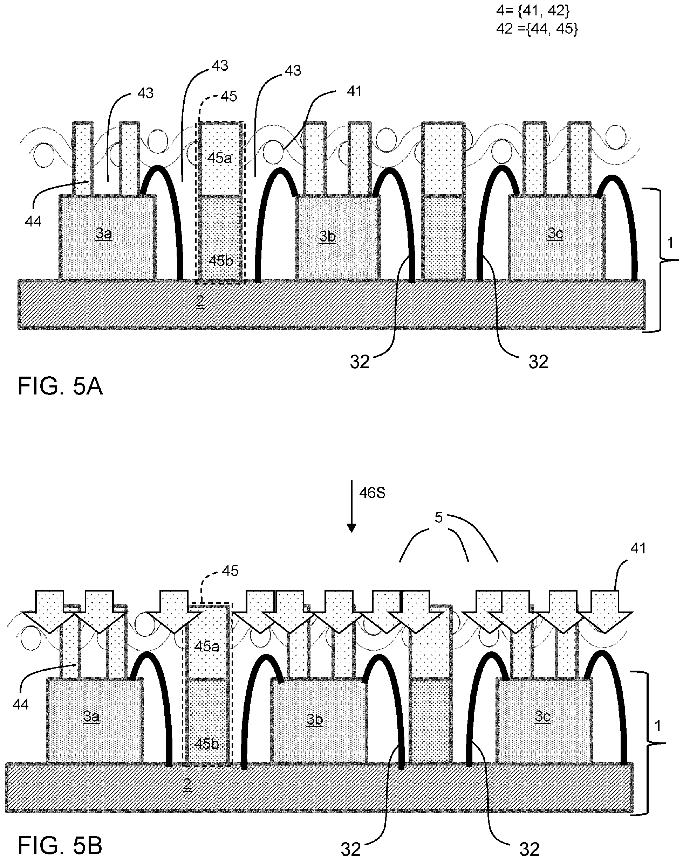

FIG. 5A, 5B show a further embodiment of the improved method. FIG. 5A shows how the screen 4 is positioned on an arrangement of wirebonded functional elements 3a, 3b, 3c on a substrate 2. FIG. 5B shows how an encapsulation material 5 is supplied from side 46S, so that it protrudes through openings 43 in the screen. As shown in FIG. 5A, the screen 4 is supported by the mask pattern elements 44,45 on the surface of the functional elements 3a, 3b, 3c and the surface of the substrate 2 respectively. Therewith a mechanical contact is avoided between the screen 4 and the electrical connections 32 with which the functional elements are wirebonded to the substrate 2. In the example shown in FIG. 5A, 5B, the mask pattern elements 44 render it possible that openings remain in the encapsulation, for example to provide external electrical connections to the functional elements. In other embodiments these mask pattern elements 44 may be absent, in which case the screen is supported by the mask pattern elements 45 only. In again other embodiments the screen 4 is supported by the mask pattern elements 44. This may in practice be sufficient if the functional elements 3a, 3b, 3c are arranged close to each other and the mask pattern elements 44 already provide sufficient support to the screen.

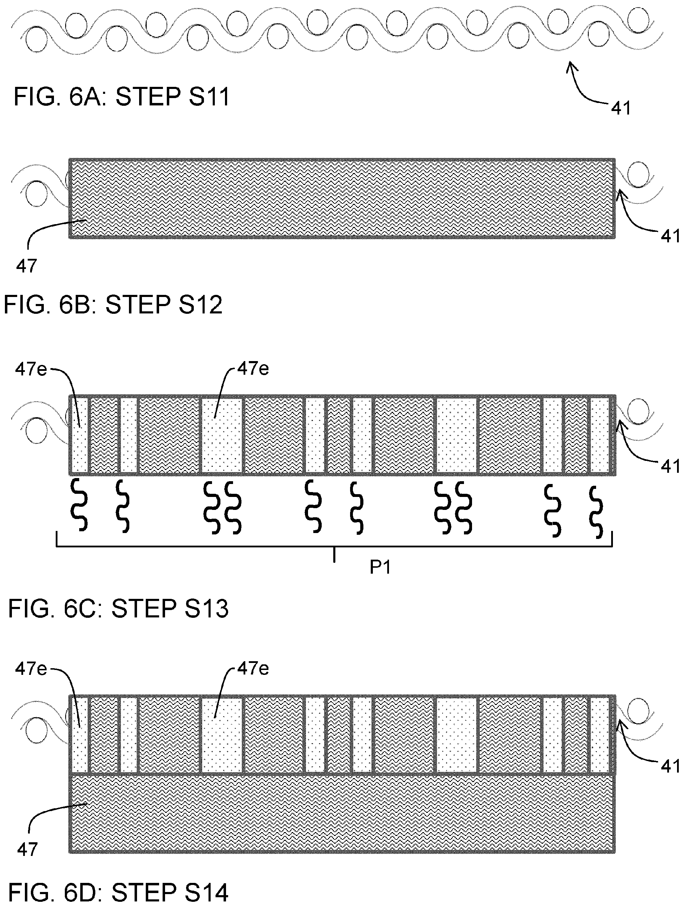

FIG. 6A to 6E Schematically shows exemplary preparatory steps wherein the screen 4 is provided that is arranged in step S1 as described with reference to FIG. 1A.

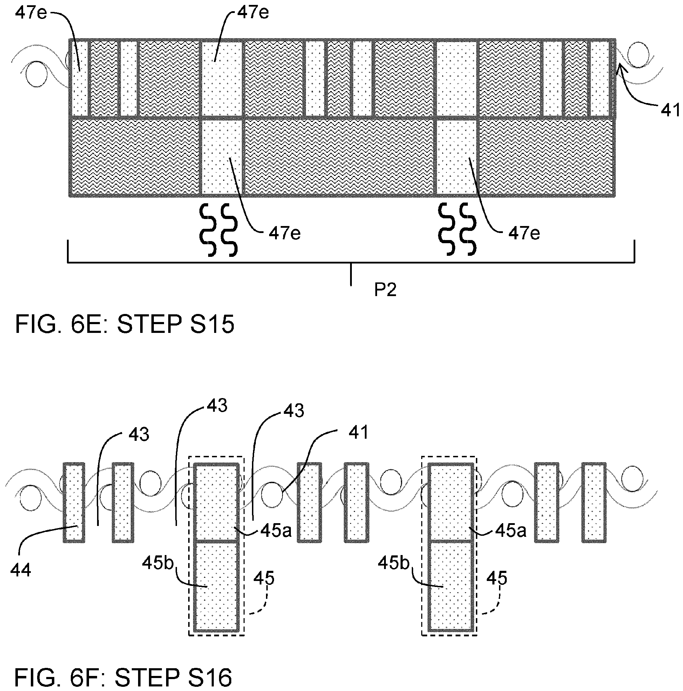

In step S12, as shown in FIG. 6B, a layer of a curable screen emulsion 47, e.g. a photopatternable material, is deposited on the screen mesh 41. Therewith the curable screen emulsion 47 partly penetrates into the screen mesh 41. In subsequent step S13 as shown in FIG. 6C, the layer of a curable screen emulsion 47 is exposed to photon radiation, for example UV radiation, in a spatial pattern P1. In the example shown, the photopatternable material 47 is a negative resist. Therewith the exposed portions 47e become cross-linked. In the subsequent step S14, shown in FIG. 6D, another layer of a curable screen emulsion 47, is deposited on the screen mesh 41. Likewise in subsequent step S15 as shown in FIG. 6E, the layer of a curable screen emulsion 47 is exposed to photon radiation, in a spatial pattern P2. Then in step S16, shown in FIG. 6F all non-crosslinked portions are dissolved, so that the remaining cured screen emulsion forms a pattern of first pattern elements 44, second pattern elements 45a conformal to the radiation pattern P1 of step S13 and a pattern of third pattern elements 45b, stacked upon the second pattern elements 45a, conformal to the radiation pattern P2 of step S15.

In an alternative example, the photopatternable material 47 is a positive resist. In that case the irradiation pattern with which the photopatternable material 47 is exposed in step S13 should be complementary to the pattern of first pattern elements 44 and second pattern elements 45a desired to be obtained in step S16. Likewise, the irradiation pattern with which the photopatternable material 47 is exposed in step S15 should be complementary to the pattern of third pattern elements 45b desired to be obtained in step S16.

The procedure can be repeated an arbitrary number of times, wherein in each cycle a layer of photopatternable material 47 is deposited and exposed according to a desired pattern (or complementary to the desired pattern in case of a positive photoresist) and after the final layer has been exposed, the remaining non-crosslinked material is dissolved. In case only a single patterned layer is desired, the non-crosslinked material can be dissolved directly after that layer is exposed in step S13.

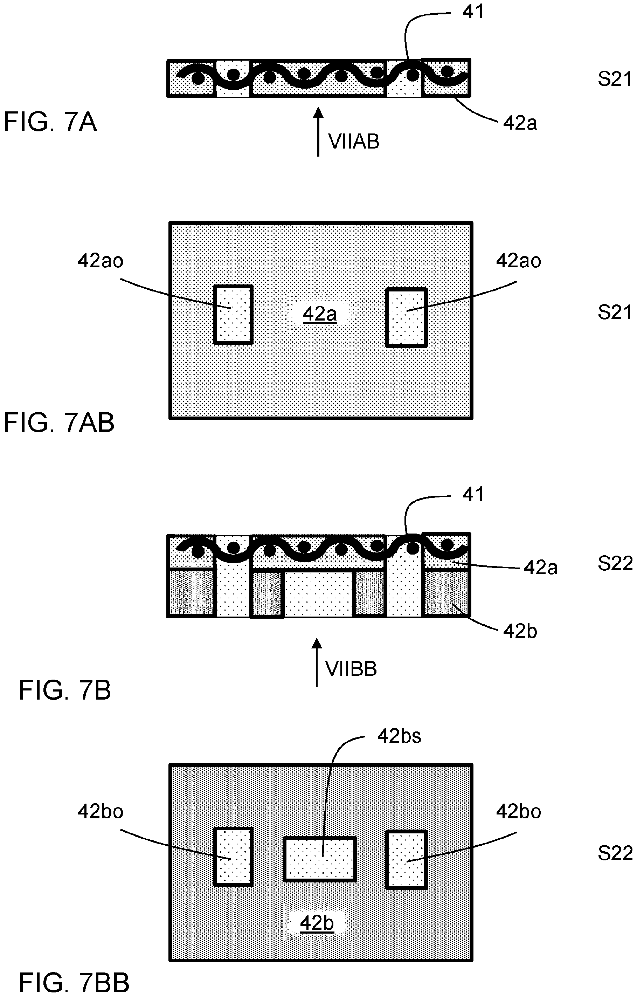

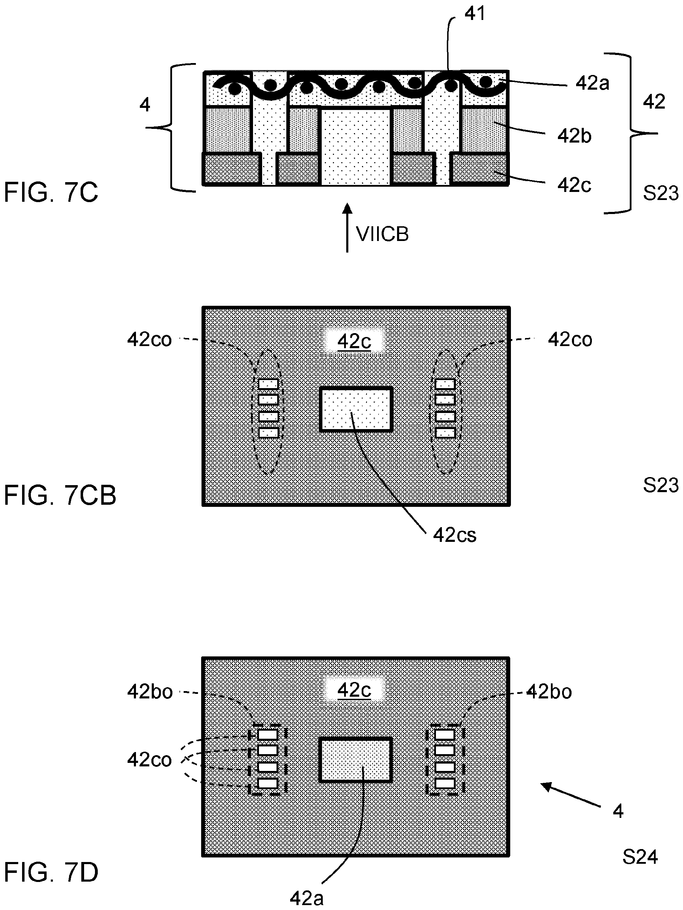

FIG. 7A, 7AB, 7B, 5BB, 7C, 7CB and 7D show how the screen as used in the application of FIG. 7A - 7C may be provided in preparatory steps S21 - S23.

FIG. 7A and 7AB shows a first preparatory step S21, wherein the first mask layer 42a is provided on the screen mesh 41 by depositing a curable screen emulsion according to a first pattern and curing the deposited curable screen emulsion by photon irradiation according to a desired pattern. Therein FIG. 7AB is a bottom view of the first mask layer 42a according to VIIAB in FIG. 7A. As shown therein the first mask layer 42a has regions of non-crosslinked material that in the final step S24 will form openings 42ao through which a solidifiable visco-plastic material can be deposited. In these and the subsequent figures 7B, 5BB, 7C, 7CB and 7D the uncured portions are shown in a lighter hatching style than the cured portions.

FIG. 7B and 7BB shows a second preparatory step S22, wherein the second mask layer 42b is provided on the first mask layer 42a by depositing a curable screen emulsion according to a second pattern and curing the deposited curable screen emulsion. Therein FIG. 7BB is a bottom view of the second mask layer 42b according to VIIBB in FIG. 7B. As shown therein the second mask layer 42b has regions of non-crosslinked material that in the final step S24 will form openings 42bo through which the solidifiable visco-plastic material can be deposited. The openings 42bo to be formed will coincide with the openings 42ao to be formed in the first mask layer 42a. The second mask layer 42b also has a region of non-crosslinked material that in step S24 will form an opening 42bs that serves to provide a space for the functional element 3.

FIG. 7C and 7CB shows a third preparatory step S23, wherein the third mask layer 42c is provided on the second mask layer 42b by depositing a curable screen emulsion according to a second pattern and curing the deposited curable screen emulsion. Therein FIG. 7CB is a bottom view of the third mask layer 42c according to VIICB in FIG. 7C. As shown therein, the third mask layer 42c has regions of non-crosslinked material that in the final step S24 will form sets of openings 42co through which the solidifiable visco-plastic material can be deposited.

FIG. 7D shows the result of a final step S24, wherein the non-crosslinked material has been dissolved. As shown therein, each set of openings 42co, as seen from the direction VIICB, is arranged within an opening 42bo of the second mask layer 42b. The opening 42cs of the third mask layer 42c coincides with the opening 42bs of the second mask layer 42b.

In the example presented in FIG. 7A, 7AB, 7B, 5BB, 7C, 7CB and 7D it is presumed that the photopatternable material 47 used for the mask layers is a negative resist. Accordingly, the regions to be exposed to photon radiation are those that are to be removed in the final step S24. In case a positive resist is used as the photopatternable material the layers should be exposed in a complementary pattern, i.e. the material that is to remain in step S24 must be exposed.

In the claims the word "comprising" does not exclude other elements or steps, and the indefinite article "a" or "an" does not exclude a plurality. A single component or other unit may fulfill the functions of several items recited in the claims. The mere fact that certain measures are recited in mutually different claims does not indicate that a combination of these measures cannot be used to advantage. Any reference signs in the claims should not be construed as limiting the scope.

## Claims

1. A method for processing an arrangement (1), comprising a substrate (2) having mounted thereon one or more functional elements (3a, 3b, 3c), the method comprising:
positioning (S1) a screen (4) against the arrangement, the screen comprising a screen mesh (41) provided with an emulsion mask (42) fixed to the screen mesh and that defines a pattern of openings (43) through the screen, the mask (42) including mask pattern elements (44,45) that extend with a mutually different distance towards the arrangement (1);
supplying (S2) a solidifiable visco-plastic material (5) from a side (46S) of the screen (4) facing away from the arrangement (1) through the openings (43) in the mask (4);
removing (S3) the screen (4);
solidification processing (S4) the solidifiable visco-plastic material (5).

2. The method according to claim 1, wherein the mask (42) includes at least one first mask pattern element (44) that contacts the at least one functional element (3a, 3b, 3c), wherein the solidifiable visco-plastic material (5) after solidification forms an encapsulation.

3. The method according to claim 2, further comprising, subsequent to removal (S3) of the screen (4), and solidification processing (S4) the solidifiable visco-plastic material, filling (S5) an opening (3o) in the encapsulation at the location where the first mask pattern element (44) contacted the functional element (3a, 3b, 3c) with a substance different from that of the encapsulation.

4. The method according to claim 3, wherein the substance different from that of the encapsulation is an electrically conductive material (6) that provides an electrical connection to an electric contact (3ae) of the at least one functional element (3a).

5. The method according to claim 3, wherein the substance different from the encapsulation material is a transparent material (6) that provides an optical pathway to a light sensor or image sensor (3ds) of the at least one functional element (3d).

6. The method according to one of the preceding claims, wherein the mask (42) includes at least one second mask pattern element (45) that contacts the substrate (2) when the screen is arranged, wherein the solidifiable visco-plastic material (5) after solidification forms an encapsulation.

7. The method according to claim 6 further comprising, subsequent to removal (S4) of the screen (4), filling (S5) an opening (2o) towards an electric contact (2e) on a surface of the substrate (2) with an electrically conductive material (6).

8. The method according to one of the preceding claims, wherein the mask (42) comprises at least one opening (43) that extends towards a surface (2s) of the substrate (2) facing the mask (42).

9. The method according to one of the preceding claims, wherein respective mask pattern elements (44e, 44f) have a respective height that is complimentary to a height of respective functional elements (3e, 3f) arranged on the substrate (2).

10. The method according to one of the preceding claims, wherein the mask pattern elements (44,45) comprise at least a first mask pattern element (44) configured to contact an upper surface of a functional element (3a) and a second mask pattern element (45) configured to extend alongside the functional element while providing for a space (1c) between the upper surface (2s) of the substrate (2) and a surface (45s) of said second mask pattern element facing the upper surface (2s) of the substrate (2).

11. The method according to one of the preceding claims, wherein the one or more functional elements comprises one or more of a die, an encapsulated die, an optical component, an electronic component, a microfluidic component or a printed structure.

12. The method according to one of the preceding claims, wherein the screen mask (42) comprises at least two mask layers (42a, 42b) of which at least one mask layer (42c) that faces the arrangement (1) comprises a set of openings (42co) that in a direction perpendicular to the mask are arranged within an opening (42bo) of another mask layer (42b).

13. The method according to one of the preceding claims, wherein at least one of the functional elements (3a, 3b, 3c) is wirebonded on the substrate (2) with electrically conducting wires (32) and wherein in said step of arranging (S1) the mask pattern elements (44,45) support the screen (4) on the surface of the functional elements (3a, 3b, 3c) and/or on the surface of the substrate (2), therewith avoiding mechanical contact between the screen (4) and the electrically conducting wires (32).

14. The method according to one of the preceding claims, comprising prior to the step of arranging (S1) a screen (4):
a step of providing (S11) the screen mesh (41);
depositing (S12) a first layer of curable screen emulsion (47) on the screen mesh (41);
curing (S13) the first layer of curable screen emulsion (47) according to a first pattern (P1), therewith providing cured screen emulsion (47e) in the form of at least a first mask pattern element (44) and cured screen emulsion (47e) in the form of at least a second pattern element (45a) within the first layer;
depositing (S14) a second layer of curable screen emulsion (47) on said first layer;
curing (S15) the second layer of curable screen emulsion (47) according to a second pattern, therewith providing cured screen emulsion (47e) in the form of at least a third pattern element (45b) in the second layer;
dissolving (S16) uncured screen emulsion in the first and the second layer, therewith obtaining a patterned mask comprising a first mask pattern element (44) and a second mask pattern element (45) comprising the second pattern element (45a) and the third pattern element (45b) stacked on the first pattern element (45a) .

15. The method according to claim 14, wherein the cured material of the at least a third pattern element (45b) has a hardness different from that of the first mask pattern element (44) and the second pattern element (45a).
